# EUROPEAN PATENT APPLICATION

(11) **EP 4 421 137 A1**
(43) Date of publication of application: **28.08.2024**
(21) Application number: 22882713.5
(22) Date of filing: 12.10.2022
(51) Int. Cl.: C09D 135/02, C09D 183/06, C09D 133/16, C09D 5/08, C08F 222/14, C08F 20/18, C08F 120/24, B05D 1/00, B05D 7/24

(54) **COMPOSITE COATING, PREPARATION METHOD, AND DEVICE**

(30) Priority: 20.10.2021 CN 202111223170
(71) Applicant: Jiangsu Favored Nanotechnology Co., Ltd., Wuxi, Jiangsu 214111 (CN)
(72) Inventor: ZONG, Jian, Wuxi, Jiangsu 214111 (CN)
(74) Representative: Mewburn Ellis LLP
(86) International application number: PCT/CN2022/124797
(87) International publication number: WO 2023/066103

(57) **Abstract**

Detailed embodiments of the present invention provide a composite coating, a preparation method, and a device. The composite coating comprises a coating formed by plasma containing an unsaturated ester monomer having an aromatic ring, an ester coupling agent monomer, and an organosilane monomer having an aromatic ring or an epoxy group as an inner layer; and a coating formed by plasma containing a fluoroacrylate monomer and an organosilane monomer having an aromatic ring or an epoxy group as the outer layer. The composite coating has both an excellent anti-corrosion performance and excellent wear resistance.

## Description

This application claims the benefit of priority to Chinese Patent Application No. 202111223170.2, filed on October 20, 2021 with China National Intellectual Property Administration, and entitled "COMPOSITE COATING, PREPARATION METHOD, AND DEVICE", the entire disclosure of which is incorporated herein by reference.

### TECHNICAL FIELD

The present disclosure relates to the field of plasma chemistry, and specifically, to a plasma polymeric composite coating, a method for preparing the same, and a device including the same.

### BACKGROUND

Electronic and electrical equipment and metal devices, etc., are very sensitive to damage from contamination caused by a liquid, especially water. For example, during normal use or accidental exposure, an electronic or electrical device may contact a liquid to lead to a short circuit between electronic elements and irreparable damage to a circuit board, an electronic chip, and the like. Protective coating may protect surfaces of different substrates to reduce vulnerability thereof to liquids. In this regard, it is a mainstream method to prepare a polymer protective coating by a vapor deposition process on a surface of a substrate, which is affordable, easy to operate, etc. Among others, in plasma chemical vapor deposition, deposition may be carried out on the surface of the substrate by activating a reactive organic monomer gas, such as, a fluorinated compound, with plasma. This process is applicable to a variety of substrates, and a uniform, thin and low-stress polymer protective coating may be deposited thereby at a low preparation temperature, with almost no damage to the surface of the substrate and almost no influence on performance of the substrate. However, the deposited coating has poor wear resistance, unstable corrosion resistance, reduced performance during transportation, and other problems.

### SUMMARY

Specific embodiments of the present disclosure provide a composite coating with an excellent anti-corrosion property and wear resistance, a method for preparing the same, and a device including the same. Specific solutions are as follows.

A composite coating including a coating I deposited on a substrate,
the coating I is a plasma polymeric coating formed from plasma containing a monomer α, a monomer β and a monomer y;
and the monomer α has a structure represented by formula (1-1), 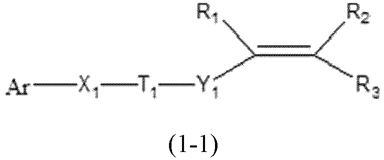
in formula (1-1), Ar is a structure with an aromatic ring, T₁ is -O-C(O)- or -C(O)-O-, X₁ is a linker, Y₁ is a linker, and R₁, R₂ and R₃ are each independently selected from a group consisting of a hydrogen atom, halogen atoms, C₁-C₁₀ alkyl groups, or C₁-C₁₀ alkyl groups substituted with a halogen atom;
the monomer β has a structure represented by formula (2-1), 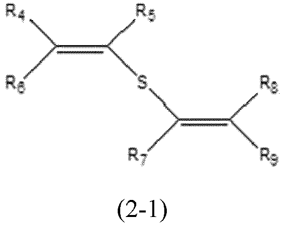
in formula (2-1), S contains above one -O-C(O)- or -C(O)-O-, and R₄, R₅, R₆, R₇, R₈ and R₉ are each independently selected from a group consisting of a hydrogen atom, halogen atoms, C₁-C₁₀ alkyl groups, or C₁-C₁₀ alkyl groups substituted with a halogen atom; and
the monomer γ has a structure represented by formula (3-1), 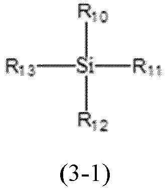
in formula (3-1), R₁₀, R₁₁, R₁₂ and R₁₃ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, and substituted or unsubstituted C₄-C₂₀ aromatic groups, and at least one of R₁₀, R₁₁, R₁₂ and R₁₃ contains an epoxy group or is a C₄-C₂₀ aromatic group.

In some embodiments, R₁, R₂, R₃, R₄, R₅, R₆, R₇, R₈ and R₉ are each independently selected from a group consisting of a hydrogen atom and a methyl group.

In some embodiments, X₁ is a structure represented by formula (1-2), 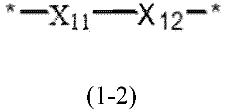
in formula (1-2), X₁₁ is a linking bond, -O- or -C(O)-, and X₁₂ is a linking bond, C₁-C₁₀ alkylidene groups, or C₁-C₁₀ alkylidene groups substituted with a halogen atom; and
Y₁ is a linking bond, C₁-C₁₀ alkylidene groups, or C₁-C₁₀ alkylidene groups substituted with a halogen atom.

In some embodiments, Ar is a benzene ring structure or a benzene ring structure with a substituent.

In some embodiments, the monomer α has a structure represented by formula (1-3), 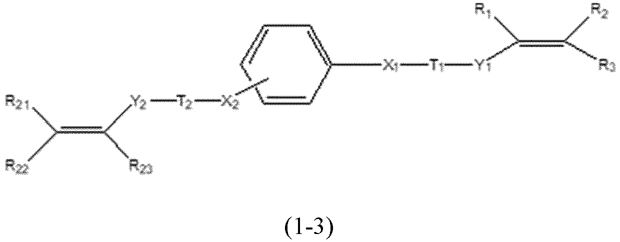
in formula (1-3), T₂ is -O-C(O)- or -C(O)-O-, X₂ is a linker, Y₂ is a linker, and R₂₁, R₂₂ and R₂₃ are each independently selected from a group consisting of a hydrogen atom, halogen atoms, C₁-C₁₀ alkyl groups, and C₁-C₁₀ alkyl groups substituted with a halogen atom.

In some embodiments, X₂ is a structure represented by the following formula (1-4), 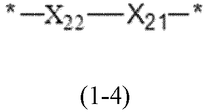
in formula (1-4), X₂₁ is a linking bond, -O- or -C(O)-, and X₂₂ is a linking bond, C₁-C₁₀ alkylidene groups, or C₁-C₁₀ alkylidene groups substituted with a halogen atom; and
Y₂ is a linking bond, C₁-C₁₀ alkylidene groups, or C₁-C₁₀ alkylidene groups substituted with a halogen atom.

In some embodiments, R₂₁, R₂₂ and R₂₃ are each independently selected from a group consisting of a hydrogen atom and a methyl group.

In some embodiments, the monomer α is at least one selected from a group consisting of 2-phenoxyethyl acrylate, benzyl acrylate, diallyl terephthalate, and phenyl methacrylate.

In some embodiments, S contains two selected from a group consisting of -O-C(O)- and -C(O)-O-, and x is above 4.

In some embodiments, S has a structure represented by formula (2-2), 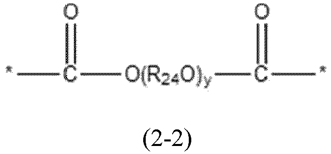 in formula (2-2), R₂₄ is C₂-C₁₀ alkylidene groups or C₂-C₁₀ alkylidene groups substituted with a halogen atom, and y is an integer from 0 to 10.

In some embodiments, the monomer β is at least one selected from a group consisting of 1,4-butanediol dimethacrylate, 1,6-hexanediol dimethacrylate, ethylene glycol dimethacrylate, diethylene glycol dimethacrylate, triethylene glycol dimethacrylate, tetraethylene glycol dimethacrylate, 1,3-butanediol dimethacrylate, neopentylene glycol dimethacrylate, methacrylic anhydride, diprop-2-enyl 2-methylidenebutanedioate, diprop-2-enyl 2-benzylidene propanedioate, and diallylmalonic acid diethyl ester.

In some embodiments, the composite coating further includes a coating II. And, the coating II is a plasma polymeric coating formed on the coating I by contacting the coating I with plasma containing a monomer δ and a monomer ε;
and the monomer δ has a structure represented by formula (4-1), 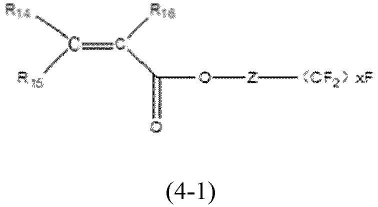
in formula (4-1), Z is a linker, R₁₄, R₁₅ and R₁₆ are each independently selected from a group consisting of a hydrogen atom, halogen atoms, C₁-C₁₀ hydrocarbyl groups, and C₁-C₁₀ hydrocarbyl groups substituted with a halogen atom, and x is an integer of 1-20; and
the monomer ε has a structure represented by formula (5-1), 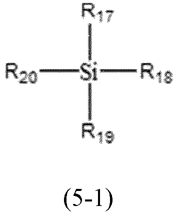
in formula (5-1), R₁₇, R₁₈, R₁₉ and R₂₀ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, or substituted or unsubstituted C₄-C₂₀ aromatic groups, and at least one of R₁₇, R₁₈, R₁₉ and R₂₀ contains an epoxy group or is a C₄-C₂₀ aromatic group.

In some embodiments, R₁₄, R₁₅ and R₁₆ are each independently selected from a group consisting of a hydrogen atom and a methyl group.

In some embodiments, Z is a linking bond, C₁-C₄ alkylidene groups, or C₁-C₄ alkylidene groups with a substituent.

In some embodiments, the monomer δ is one or more selected from a group consisting of 3-(perfluoro-5-methylhexyl)-2-hydroxypropyl methacrylate, 2-(perfluorodecyl)ethyl methacrylate, 2-(perfluorohexyl)ethyl methacrylate, 2-(perfluorododecyl)ethyl acrylate, 2-perfluorooctyl ethyl acrylate, 1H,1H,2H,2H-perfluorooctyl acrylate, 2-(perfluorobutyl)ethyl acrylate, (2H-perfluoropropyl)-2-propenyl ether, and (perfluorocyclohexyl)methyl acrylate.

In some embodiments, R₁₀, R₁₁, R₁₂, R₁₃, R₁₇, R₁₈, R₁₉ and R₂₀ are each independently selected from a group consisting of a hydrogen atom, halogen atoms, C₁-C₂₀ hydrocarbyl groups, C₁-C₂₀ hydrocarbyl groups with a substituent of an epoxy structure, C₁-C₂₀ hydrocarbyloxy groups, C₁-C₂₀ hydrocarbyloxy groups with a substituent of an epoxy structure, and C₆-C₂₀ aryl groups.

In some embodiments, R₁₀, R₁₁, R₁₂, R₁₃, R₁₇, R₁₈, R₁₉ and R₂₀ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, and C₆-C₂₀ aryl groups, and at least one of R₁₀, R₁₁, R₁₂ and R₁₃ is a C₆-C₂₀ aryl group, at least one of R₁₇, R₁₈, R₁₉ and R₂₀ is a C₆-C₂₀ aryl group.

In some embodiments, the aryl group is phenyl.

In some embodiments, the monomer γ and the monomer ε are each independently one or more selected from a group consisting of phenyltrichlorosilane, diphenylchlorosilane, diphenyldichlorosilane, triphenylvinylsilane, diphenyldivinylsilane, phenyltrivinylsilane, methylphenyldivinylsilane, dimethylphenylvinylsilane, methoxytriphenylsilane, diphenyldimethoxysilane, and phenyltrimethoxysilane.

In some embodiments, R₁₀, R₁₁, R₁₂, R₁₃, R₁₇, R₁₈, R₁₉ and R₂₀ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, C₂-C₁₀ epoxyhydrocarbyloxyhydrocarbyl groups, and C₂-C₁₀ epoxyhydrocarbyl groups; and at least one of R₁₀, R₁₁, R₁₂ and R₁₃ is a C₂-C₁₀ epoxyhydrocarbyloxyhydrocarbyl group or a C₂-C₁₀ epoxyhydrocarbyl group, at least one of R₁₇, R₁₈, R₁₉ and R₂₀ is a C₂-C₁₀ epoxyhydrocarbyloxyhydrocarbyl group or a C₂-C₁₀ epoxyhydrocarbyl group.

In some embodiments, the epoxy is a cycloaliphatic epoxy.

In some embodiments, the monomer γ and the monomer ε are each independently one or more selected from a group consisting of 3-(2,3-epoxypropoxy)propylmethyldimethoxysilane, 3-(2,3-epoxypropoxy)propylmethyldiethoxysilane, 3-(2,3-epoxypropoxy)propyltrimethoxysilane, 3-(2,3-epoxypropoxy)propyltriethoxysilane, β-(3,4-epoxycyclohexyl)-ethyltrimethoxysilane, and 2-(3,4-epoxycyclohexyl)ethyltriethoxysilane.

In some embodiments, the substrate is a metal, a plastic, a fabric, glass, an electrical component, an optical instrument, or an electrical part.

A method for preparing any of the above composite coatings, which includes:
providing a substrate to place it in a plasma reaction chamber, evacuating the plasma reaction chamber to 20 millitorr-250 millitorr, and introducing a gas of He, Ar, O₂ or a mixed gas thereof into the plasma reaction chamber; and
introducing a vapor of the monomer α, a vapor of the monomer β and a vapor of the monomer γ into the plasma reaction chamber, and performing plasma discharge, to form the plasma polymeric coating I.

In some embodiments, the method further includes introducing a vapor of the monomer δ and a vapor of the monomer ε into the plasma reaction chamber, and performing plasma discharge, to form the plasma polymeric coating II on the coating I.

In some embodiments, the plasma is pulsed plasma.

In some embodiments, the pulsed plasma is generated by applying impulsive voltage discharge with a pulse power of 10 W-300 W, a pulse frequency of 15 Hz-60 kHz and a pulse duty factor of 1%-85%, for a plasma discharge time of 100 seconds-36000 seconds.

A device having any of the above-mentioned composite coatings on at least a part of a surface of the device.

The composite coating according to the specific embodiments of the present disclosure is a plasma coating formed by introducing two monomers of an unsaturated ester compound with an aromatic ring and an organosilane with an aromatic group or an epoxy group simultaneously. The unsaturated ester compound has an aromatic ring, which has good stability and thus enables the coating to have relatively good hardness, corrosion resistance, heat resistance and temperature resistance, while having improved hydrophobicity property and reduced water solubility. In addition, the unsaturated ester compound contains an ester group or a carboxyl group, and thus, may form a hydrogen bond force. Also, the organosilane has relatively good chemical bonding forces at two ends to an organic substance and an inorganic substance, respectively, and thus has a relatively good adhering and bonding effect on the substrate.

The composite coating according to the specific embodiments of the present disclosure is a plasma coating formed by introducing two monomers of a fluoride and an organosilane simultaneously. The organosilane may form a stable bond with a surface of the substrate or with an anti-corrosion layer. Moreover, addition of a fluorine group may improve hydrophobic and oleophobic properties, and at the same time, there is a relatively good chemical bonding between the fluoride and the silane, and the coating may thus have improved wear resistance.

The composite coating according to the specific embodiments of the present disclosure has a coating formed from plasma containing an unsaturated ester monomer with an aromatic ring, an ester coupling agent monomer and an organosilane monomer with an aromatic group or an epoxy group as an inner layer, and has a coating formed from plasma containing a fluorine-containing acrylate monomer and the organosilane monomer with the aromatic group or the epoxy group as an outer layer, as well as has excellent anti-corrosion property while having excellent wear resistance.

### BRIEF DESCRIPTION OF THE DRAWINGS

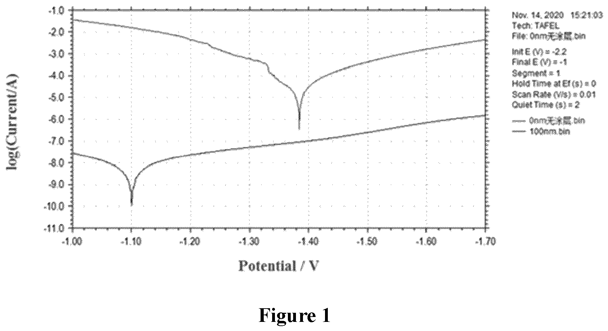

Figure 1 is a Tafel curve obtained by electrochemical testing on a coated Mg sheet and an uncoated Mg sheet in Example 2.

### DETAILED DESCRIPTION

Specific embodiments of the present disclosure provide a composite coating including a coating I deposited on a substrate,
the coating I is a plasma polymeric coating formed from plasma containing a monomer α, a monomer β and a monomer y;
and the monomer α has a structure represented by formula (1-1), 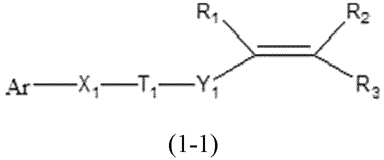
in formula (1-1), Ar is a structure with an aromatic ring, T₁ is -O-C(O)- or -C(O)-O-, X₁ is a linker, Y₁ is a linker, and R₁, R₂ and R₃ are each independently selected from a group consisting of a hydrogen atom, halogen atoms, C₁-C₁₀ alkyl groups, or C₁-C₁₀ alkyl groups substituted with a halogen atom;
the monomer β has a structure represented by formula (2-1), 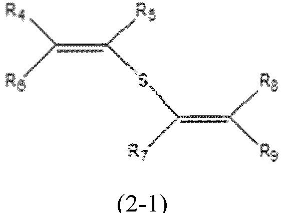
in formula (2-1), S contains above one -O-C(O)- or -C(O)-O-, and R₄, R₅, R₆, R₇, R₈ and R₉ are each independently selected from a group consisting of a hydrogen atom, halogen atoms, C₁-C₁₀ alkyl groups, or C₁-C₁₀ alkyl groups substituted with a halogen atom; and
the monomer γ has a structure represented by formula (3-1), 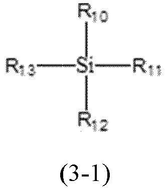
in formula (3-1), R₁₀, R₁₁, R₁₂ and R₁₃ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, and substituted or unsubstituted C₄-C₂₀ aromatic groups, and at least one of R₁₀, R₁₁, R₁₂ and R₁₃ contains an epoxy group or is a C₄-C₂₀ aromatic group.

In some specific embodiments, the composite coating further includes a coating II. And, the coating II is a plasma polymeric coating formed on the coating I by contacting the coating I with plasma containing a monomer δ and a monomer ε;
and the monomer δ has a structure represented by formula (4-1), 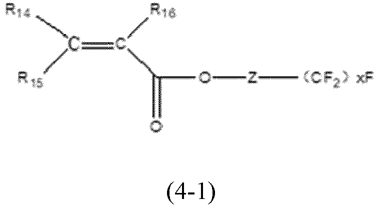
in formula (4-1), Z is a linker, R₁₄, R₁₅ and R₁₆ are each independently selected from a group consisting of a hydrogen atom, halogen atoms, C₁-C₁₀ hydrocarbyl groups, and C₁-C₁₀ hydrocarbyl groups substituted with a halogen atom, and x is an integer of 1-20; and
the monomer ε has a structure represented by formula (5-1), 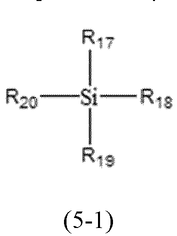
in formula (5-1), R₁₇, R₁₈, R₁₉ and R₂₀ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, or substituted or unsubstituted C₄-C₂₀ aromatic groups, and at least one of R₁₇, R₁₈, R₁₉ and R₂₀ contains an epoxy group or is a C₄-C₂₀ aromatic group.

In some specific embodiments, Ar is a benzene ring or a heteroaromatic ring with a substituent on the aromatic ring. In some other specific embodiments, Ar is a benzene ring or a heteroaromatic ring without a substituent on the aromatic ring.
X₁ and Y₁ are linkers, and X₁ is used to connect a structure of Ar with an aromatic ring and an ester bond of T₁, Y₁ is used to connect the ester bond of T₁ and a saturated carbon-carbon double bond. In some specific embodiments, X₁ is a structure represented by the following formula (1-2), 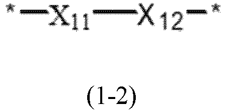
in formula (1-2), X₁₁ is a linking bond, -O- or -C(O)-, and X₁₂ is a linking bond, C₁-C₁₀ alkylidene groups, or C₁-C₁₀ alkylidene groups substituted with a halogen atom; and Y₁ is a linking bond, C₁-C₁₀ alkylidene groups, or C₁-C₁₀ alkylidene groups substituted with a halogen atom. Here, the alkylidene groups may include straight-chain alkylidene groups or alkylidene groups containing a branched chain. The straight-chain alkylidene groups may be, for example, methylene, ethylidene, propylidene, or butylidene, or the like. And, the alkylidene groups containing a branched chain may be, for example, isopropylidene, or isobutylidene, or the like.

In some specific embodiments, R₁, R₂, R₃, R₄, R₅, R₆, R₇, R₈, R₉, R₁₄, R₁₅ and R₁₆ are each independently selected from a group consisting of a hydrogen atom and a methyl group.

In some specific embodiments, the monomer α has a structure represented by formula (1-3), 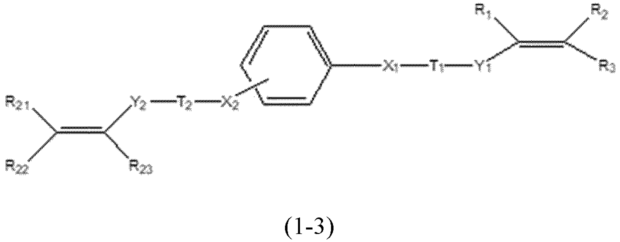
in formula (1-3), T₂ is -O-C(O)- or -C(O)-O-, X₂ is a linker used to connect a benzene ring and an ester bond of T₂, and Y₂ is a linker used to connect the ester bond of T₂ and a carbon-carbon double bond; and
R₂₁, R₂₂ and R₂₃ are each independently selected from a group consisting of a hydrogen atom, halogen atoms, C₁-C₁₀ alkyl groups, and C₁-C₁₀ alkyl groups substituted with a halogen atom. Here, the alkyl groups may include straight-chain alkyl groups or alkyl groups containing a branched chain. The straight-chain alkyl groups may be, for example, methyl, ethyl, propyl, or butyl, or the like. And, the alkyl groups containing a branched chain may be, for example, isopropyl, or isobutyl, or the like.

In the structure represented by formula (1-3), the two substituents on the benzene ring are para-substituents in some specific embodiments, and may also be ortho-substituents or meta-substituents in some other embodiments.

In some specific embodiments, X₂ is a structure represented by the following formula (1-4), 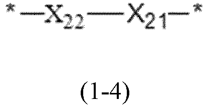 in formula (1-4), X₂₁ is a linking bond, -O- or -C(O)-, and X₂₂ is a linking bond, C₁-C₁₀ alkylidene groups, or C₁-C₁₀ alkylidene groups substituted with a halogen atom; and Y₂ is a linking bond, C₁-C₁₀ alkylidene groups, or C₁-C₁₀ alkylidene groups substituted with a halogen atom. Here, the alkylidene groups may include straight-chain alkylidene groups or alkylidene groups containing a branched chain. The straight-chain alkylidene groups may be, for example, methylene, ethylidene, propylidene, or butylidene, or the like. And, the alkylidene groups containing a branched chain may be, for example, isopropylidene, or isobutylidene, or the like.

In some specific embodiments, R₂₁, R₂₂ and R₂₃ are each independently selected from a group consisting of a hydrogen atom and a methyl group.

As a specific nonrestrictive example, the monomer α is at least one selected from a group consisting of 2-phenoxyethyl acrylate (CAS#: 48145-04-6), benzyl acrylate (CAS#: 937-41-7), diallyl terephthalate (CAS#: 1026-92-2), and phenyl methacrylate (CAS#: 2177-70-0).

In some specific embodiments, S contains two selected from a group consisting of - O-C(O)- and -C(O)-O-, that is, S contains two -O-C(O)--, or two -C(O)-O-, or one -O-C(O)- and one -C(O)-O-; and x is above 4, and may be, for example, 4, 5, 6, 7, 8, 9, 10, 11, or 12, or the like.

In some specific embodiments, S has a structure represented by formula (2-2), 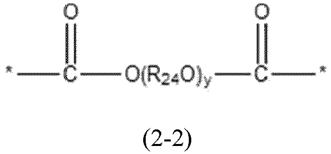 in formula (2-2), R₂₄ is C₂-C₁₀ alkylidene groups or C₂-C₁₀ alkylidene groups substituted with a halogen atom, and y is an integer from 0 to 10. Here, the alkylidene groups may include straight-chain alkylidene groups or alkylidene groups containing a branched chain. The straight-chain alkylidene groups may be, for example, methylene, ethylidene, propylidene, or butylidene, or the like. And, the alkylidene groups containing a branched chain may be, for example, isopropylidene, or isobutylidene, or the like. And, y is specifically 0, 1, 2, 3, 4, 5, 6, 7, 8, 9, or 10.

As a specific nonrestrictive example, the monomer β is at least one selected from a group consisting of 1,4-butanediol dimethacrylate (CAS#: 2082-81-7), 1,6-hexanediol dimethacrylate (CAS#: 6606-59-3), ethylene glycol dimethacrylate (CAS#: 97-90-5), diethylene glycol dimethacrylate (CAS#: 2358-84-1), triethylene glycol dimethacrylate (CAS#: 109-16-0), tetraethylene glycol dimethacrylate (CAS#: 109-17-1), 1,3-butanediol dimethacrylate (CAS#: 1189-08-8), neopentylene glycol dimethacrylate (CAS#: 1985-51-9), methacrylic anhydride (CAS#: 760-93-0), diprop-2-enyl 2-methylidenebutanedioate, diprop-2-enyl 2-benzylidene propanedioate (CAS#: 52505-39-2), and diallylmalonic acid diethyl ester (CAS#: 3195-24-2).

Z is a linker used to connect an ester bond and a perfluoroalkyl group. In some specific embodiments, Z is a linking bond, C₁-C₄ alkylidene groups, or C₁-C₄ alkylidene groups with a substituent. Here, the alkylidene groups may include straight-chain alkylidene groups or alkylidene groups containing a branched chain. The straight-chain alkylidene groups may be, for example, methylene, ethylidene, propylidene, or butylidene, or the like. And, the alkylidene groups containing a branched chain may be, for example, isopropylidene, or isobutylidene, or the like. The substituent may include, for example, halogen atoms, a hydroxy group, a carboxy group, or an ester group, or the like.

In some specific embodiments, x is above 4, and further, above 6. For example, x is specifically 6, 7, 8, 9, 10, 11, 12, 13, 14, 15, 16, 17, 18, 19, or 20, which is conducive to improving hydrophobicity property of the coating.

As a specific nonrestrictive example, the monomer δ is one or more selected from a group consisting of 3-(perfluoro-5-methylhexyl)-2-hydroxypropyl methacrylate (CAS#: 16083-81-1), 2-(perfluorodecyl)ethyl methacrylate (CAS#: 2144-54-9), 2-(perfluorohexyl)ethyl methacrylate (CAS#: 2144-53-8), 2-(perfluorododecyl)ethyl acrylate (CAS#: 27905-45-9), 2-perfluorooctyl ethyl acrylate (CAS#: 27905-45-9), 1H,1H,2H,2H-perfluorooctyl acrylate (CAS#: 17527-29-6), 2-(perfluorobutyl)ethyl acrylate (CAS#: 52591-27-2), (2H-perfluoropropyl)-2-propenyl ether (CAS#: 59158-81-5), and (perfluorocyclohexyl)methyl acrylate (CAS#: 40677-94-9).

R₁₀, R₁₁, R₁₂ and R₁₃ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, and substituted or unsubstituted C₄-C₂₀ aromatic groups, and at least one of R₁₀, R₁₁, R₁₂ and R₁₃ contains an epoxy group or is a C₄-C₂₀ aromatic group. R₁₇, R₁₈, R₁₉ and R₂₀ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, and substituted or unsubstituted C₄-C₂₀ aromatic groups, and at least one of R₁₇, R₁₈, R₁₉ and R₂₀ contains an epoxy group or is a C₄-C₂₀ aromatic group. Here, the hydrocarbyl groups may be alkyl groups, alkenyl groups or alkynyl groups, and may further be cycloaliphatic hydrocarbyl groups or aryl hydrocarbyl groups; the hydrocarbyloxy groups may be alkoxy groups, alkenyloxy groups or alkynyloxy groups, and may further be cycloaliphatic hydrocarbyloxy groups or aryl hydrocarbyloxy groups; the substituent for substitution may be, for example, a halogen atom, an epoxy group, a nitro group, a cyano group, a sulfonic acid group, an amino group, a carboxyl group, a hydroxyl group, a sulfhydryl group, a hydrocarbyl group, an hydrocarbyloxy group, or an acyl group, or the like, and may be one or two or more in number; and the aromatic groups may be aryl groups or heteroaryl groups.

In some specific embodiments, R₁₀, R₁₁, R₁₂, R₁₃, R₁₇, R₁₈, R₁₉ and R₂₀ are each independently selected from a group consisting of a hydrogen atom, halogen atoms, C₁-C₂₀ hydrocarbyl groups, C₁-C₂₀ hydrocarbyl groups with a substituent of an epoxy structure, C₁-C₂₀ hydrocarbyloxy groups, C₁-C₂₀ hydrocarbyloxy groups with a substituent of an epoxy structure, and C₆-C₂₀ aryl groups.

In some specific embodiments, R₁₀, R₁₁, R₁₂, R₁₃, R₁₇, R₁₈, R₁₉ and R₂₀ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, and C₆-C₂₀ aryl groups, and at least one of R₁₀, R₁₁, R₁₂ and R₁₃ is a C₆-C₂₀ aryl group, at least one of R₁₇, R₁₈, R₁₉ and R₂₀ is a C₆-C₂₀ aryl group. As an example, the alkyl groups may be, for example, methyl, ethyl, propyl, butyl, or isopropyl, or the like; the alkoxy groups may be, for example, methoxy, ethoxy, propoxy, butoxy, or isopropoxy, or the like; the alkenyl groups may be, for example, vinyl, propenyl, or butenyl, or the like; the alkenyloxy groups may be, for example, 2-(allyloxy); and the aryl groups may be, for example, phenyl, p-methylphenyl, or biphenyl, or the like. In some specific embodiments, more specifically, the monomer γ and the monomer ε are each independently one or more selected from a group consisting of phenyltrichlorosilane (CAS#: 98-13-5), diphenylchlorosilane (CAS#: 1631-83-0), diphenyldichlorosilane (CAS#: 80-10-4), triphenylvinylsilane (CAS#: 18666-68-7), diphenyldivinylsilane (CAS#: 17937-68-7), phenyltrivinylsilane (CAS#: 18042-57-4), methylphenyldivinylsilane, dimethylphenylvinylsilane (CAS#: 1125-26-4), methoxytriphenylsilane (CAS#: 1829-41-0), diphenyldimethoxysilane (CAS#: 6843-66-9), and phenyltrimethoxysilane (CAS#: 2996-92-1).

In some specific embodiments, R₁₀, R₁₁, R₁₂, R₁₃, R₁₇, R₁₈, R₁₉ and R₂₀ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, C₂-C₁₀ epoxyhydrocarbyloxyhydrocarbyl groups, and C₂-C₁₀ epoxyhydrocarbyl groups, and at least one of R₁₀, R₁₁, R₁₂ and R₁₃ is a C₂-C₁₀ epoxyhydrocarbyloxyhydrocarbyl group or a C₂-C₁₀ epoxyhydrocarbyl group, at least one of R₁₇, R₁₈, R₁₉ and R₂₀ is a C₂-C₁₀ epoxyhydrocarbyloxyhydrocarbyl group or a C₂-C₁₀ epoxyhydrocarbyl group. As an example, the alkyl groups may be, for example, methyl, ethyl, propyl, butyl, or isopropyl, or the like; the alkoxy groups may be, for example, methoxy, ethoxy, propoxy, butoxy, or isopropoxy, or the like; the alkenyl groups may be, for example, vinyl, propenyl, or butenyl, or the like; the alkenyloxy groups may be, for example, 2-(allyloxy); the epoxyhydrocarbyloxyhydrocarbyl groups may be, for example, (2,3-epoxypropoxy)ethyl, (2,3-epoxypropoxy)propyl, (3,4-epoxybutoxy)ethyl, or (3,4-epoxybutoxy)propyl, or the like; and the epoxyhydrocarbyl groups may be, for example, 2,3-epoxypropyl, 3,4-epoxyethyl, 3,4-epoxybutyl, or 3,4-epoxycyclohexyl, or the like. In some specific embodiments, the epoxy is a cycloaliphatic epoxy, such as 3,4-epoxycyclohexyl. In some specific embodiments, and more specifically, the monomer γ and the monomer ε are each independently one or more selected from a group consisting of 3-(2,3-epoxypropoxy)propylmethyldimethoxysilane (CAS#: 65799-47-5), 3-(2,3-epoxypropoxy)propylmethyldiethoxysilane (CAS#: 2897-60-1), 3-(2,3-epoxypropoxy)propyltrimethoxysilane (CAS#: 2530-83-8), 3-(2,3-epoxypropoxy)propyltriethoxysilane (CAS#: 2602-34-8), β-(3,4-epoxycyclohexyl)-ethyltrimethoxysilane (CAS#: 3388-04-3), and 2-(3,4-epoxycyclohexyl)ethyltriethoxysilane (CAS#: 10217-34-2).

In some specific embodiments, the substrate is a metal, a plastic, a fabric, glass, an electrical component, an optical instrument, or an electrical part. Specifically, the metal may be, for example, iron, magnesium, aluminum, copper or alloys thereof; the electrical component may be, for example, printed circuit boards (PCBs), electronic products, or semi-finished electronic assembly products, or the like, and the electronic products may be, for example, computers, smart phones, tablets, keyboards, e-readers, wearable devices, displays, earphones, and the like; and the electrical part may be, for example, data cables (such as Type-C data cables, USB data cables, etc.), sound transmission meshes, resistors, capacitors, transistors, diodes, amplifiers, relays, transformers, batteries, fuses, integrated circuits, switches, LEDs, LED displays, piezoelectric elements, optoelectronic parts, or antennas, or oscillators, or the like.

In some specific embodiments, the substrate is a glass screen, in particular a mobile phone screen. Smart phone has been popularized at present, and a lot of mobile phone manufacturers will choose glass coated with an anti-fingerprint coating as a mobile phone screen in terms of the problem of waterproofing and anti-fingerprint in mobile phone. Traditional anti-fingerprint coating processes are performed by mainly a physical vapor deposition process and a wet spraying process. These two later processes, however, are relatively expensive and require relatively harsher experimental conditions. The plasma polymeric coating according to the specific embodiments of the present disclosure is more easily prepared by a plasma chemical vapor deposition process, and is uniform, thin and low in stress. In addition, the coating according to the present disclosure causes almost no damage to a surface of the substrate and almost no influence on performance of the substrate, and greatly improves waterproof and oil-proof properties of the mobile phone during use, while having excellent wear resistance and anti-corrosion property, and is especially suitable for use as a protective coating for glass screens such as mobile phone screens.

A ratio among the monomer α, the monomer β and the monomer γ may be adjusted, according to a specific monomer situation. In some specific embodiments, a molar ratio of the monomer α to the monomer β is between 3:10-10:3, and may be, for example, 3:10, 4:10, 5:10, 6:10, 7:10, 8:10, 9:10, 10:10, 10:9, 10:8, 10:7, 10:6, 10:5, 10:4, or 10:3, or the like. And, a molar ratio of the monomer α to the monomer γ is between 1:10-10:1, and may specifically be, for example, 1:10, 2:10, 3:10, 4:10, 5:10, 6:10, 7:10, 8:10, 9:10, 10:10, 10:9, 10:8, 10:7, 10:6, 10:5, 10:4, 10:3, 10:2, 10:1, or the like.

A ratio of the monomer δ to the monomer ε may be adjusted, according to a specific monomer situation. In some specific embodiments, a molar ratio of the monomer δ to the monomer ε is between 3:10-10:3, and may specifically be, for example, 3:10, 4:10, 5:10, 6:10, 7:10, 8:10, 9:10, 10:10, 10:9, 10:8, 10:7, 10:6, 10:5, 10:4, or 10:3, or the like.

In some specific embodiments, the coating I is a plasma polymeric coating formed from plasma of the monomer α, the monomer β and the monomer γ, and the coating II is a plasma polymeric coating formed on the coating I by contacting the coating I with plasma of the monomer δ and the monomer ε. In some other specific embodiments, further according to actual requirements, the coating I may also be formed from plasma of the monomer α, the monomer β, the monomer γ and another monomer, and the coating II is a plasma polymeric coating formed on the coating I by contacting the coating I with plasma of the monomer δ, the monomer ε, and another monomer.

The specific embodiments of the present disclosure further provide a method for preparing the composite coatings described above, which includes:
providing a substrate to place it in a plasma reaction chamber, evacuating the plasma reaction chamber to 20 millitorr-250 millitorr, and introducing a gas of He, Ar, O₂ or a mixed gas thereof into the plasma reaction chamber; and
introducing a vapor of the monomer α, a vapor of the monomer β and a vapor of the monomer γ into the plasma reaction chamber, and performing plasma discharge, to form the plasma polymeric coating I.

Further, the method further includes introducing a vapor of the monomer δ and a vapor of the monomer ε into the plasma reaction chamber, and performing plasma discharge, to form the plasma polymeric coating II on the coating I.

For the method for preparing the composite coatings according to the specific embodiments of the present disclosure, the monomer α, the monomer β, the monomer γ, the monomer δ, the monomer ε, the coating I, the coating II and the substrate, etc., are as described above.

For some substrates, such as mobile phone screens or circuit boards in the method for preparing the composite coatings according to the specific embodiments of the present disclosure, in order to further enhance the binding force between the plasma coating and the substrate, the substrate may be pretreated with continuous plasma before coating in some specific embodiments. Specifically, the substrate may be pretreated, for example, in an inert gas atmosphere, with a plasma discharge power of 20 W-500 W, in a continuous discharge mode, for a continuous discharge time of 1 min-60 min, or may be pretreated with heat, oxygen, or high-energy radiation, or the like.

In some specific embodiments, the plasma is pulsed plasma. In some specific embodiments, the monomers may be at a flow rate of 50 ul/min-3000 ul/min, and specifically of, for example, 100 ul/min, 200 ul/min, 300 ul/min, 400 ul/min, 500 ul/min, 1000 ul/min, 1500 ul/min, 2000 ul/min, 2500 ul/ min, or 3000 ul/min, or the like. In some specific embodiments, the plasma reaction chamber may have a temperature controlled at 20 °C-80 °C, for example, at 20 °C, 30 °C, 40 °C, 50 °C, 60 °C, 70 °C, or 80 °C, or the like. In some specific embodiments, the monomers may be vaporized at a temperature of 50 °C-180 °C, and specifically of, for example, 50 °C, 60 °C, 70 °C, 80 °C, 90 °C, 100 °C, 110 °C, 120 °C, 130 °C, 140 °C, 150 °C, 160 °C, 170 °C, or 180°C, or the like, under a vacuum condition. In some specific embodiments, the pulse plasma is generated by applying pulse voltage discharge with a pulse power of 10 W-300 W, and specifically of, for example, 10 W, 20 W, 30 W, 40 W, 50 W, 60 W, 70 W, 80 W, 90 W, 100 W, 120W, 140 W, 160 W, 180 W, 190 W, 200 W, 210 W, 220 W, 230 W, 240 W, 250 W, 260 W, 270 W, 280 W, 290 W, or 300 W, or the like, with a pulse frequency of 15 Hz-60 kHz, and specifically of, for example, 15 Hz, 20 Hz, 25 Hz, 30 Hz, 35 Hz, 40 Hz, 45 Hz, 50 Hz, 55 Hz, 60 Hz, 70 Hz, 80 Hz, 90 Hz, 100 Hz, 200 Hz, 300 Hz, 400 Hz, 500 Hz, 600 Hz, 700 Hz, 800 Hz, 900 Hz, 1 kHz, 2 kHz, 3 kHz, 4 kHz, 5 kHz, 10 kHz, 15 kHz, 20 kHz, 30 kHz, 40 kHz, 50 kHz, or 60 kHz, or the like, and with a pulse duty factor of 1%~85%, and specifically of, for example, 1%, 5%, 10%, 15%, 20%, 25%, 30%, 35%, 40%, 45%, 50%, 55%, 60%, 65%, 70%, 75%, 80%, or 85%, or the like, for a plasma discharge time of 100 seconds-36000 seconds, and specifically of, for example, 100 seconds, 500 seconds, 1000 seconds, 2000 seconds, 3000 seconds, 4000 seconds, 5000 seconds, 6000 seconds, 7000 seconds, 8000 seconds, 9000 seconds, 10000 seconds, 15000 seconds, 20000 seconds, 25000 seconds, 30000 seconds, or 36000 seconds, or the like.

In some specific embodiments, mode of the plasma discharge may be various existing discharge modes, and specifically, may be, for example, electrodeless discharge (such as radio frequency inductive coupling discharge, microwave discharge), single electrode discharge (such as corona discharge, plasma jet formed by unipolar discharge), double electrode discharge (such as dielectric barrier discharge, radio frequency glow discharge with bare electrode), and multi-electrode discharge (such as discharge with a floating electrode as a third electrode).

The specific embodiments of the present disclosure further provide a device having any of the above-mentioned composite coatings on at least a part of a surface of the device. In some specific embodiments, part or all of the surface of the device is coated with only the protective coating described above.

The present disclosure will be further described below by specific examples.

### Examples

### Description of the test methods

Salt spray resistance test: a salt spray resistance test was performed according to GB/T 2423.18-2000 environmental test method for electrical and electronic products.

Testing on Coating for Thickness: testing on coating for thickness was performed using the Filmetrics F20-UV-Film Thickness Tester from the United States.

Circuit board friction test: a circuit board was rubbed on a wear resistance testing machine, with dust-free cloth, under a load of 200 g, for 50 times, at a rotation speed of 40 r/min, and for travel of 30 mm; the rubbed circuit board was soaked in water, applied with a voltage of 5 V, and detected for current by a computer, to record a failure time (current > 0.6 mA).

Mobile phone screen friction test: a mobile phone screen was rubbed on a wear resistance testing machine, with dust-free cloth, under a load of 100 g, and at rotation speed of 50 r/min; and a water contact angle and oil contact angle of n-hexadecane were recorded every 100 rubs.

Electrochemical test: a polarization curve in a neutral solution of 3.6% NaCl was tested by a CHI660E C20704 electrochemical analyzer manufactured by Shanghai Chenhua corporation, under a corrosion potential of negative 600 mv-positive 600 mv, at a scanning rate of 0.00033 mv/s, for a scanning time of 600 seconds.

### Example 1

A circuit board, a Mg sheet, a Fe sheet and a mobile phone screen were placed in a plasma chamber. The chamber was then evacuated to 60 millitorr, and introduced with helium at a flow rate of 80 sccm, followed by starting plasma discharge for pertreatment with a discharge power of 120W, for continuous discharge of 800 seconds, during this pretreatment stage.

Then, phenyltrimethoxysilane and a mixed monomer of 1,6-hexanediol diacrylate and phenyl methacrylate (mass ratio of 2:1) were vaporized at a temperature of 180 °C and introduced at a flow rate of 300 ul/min, respectively, into the plasma chamber, followed by starting plasma discharge with a supply power of 40 W, a frequency of 45 Hz and a duty factor of 35%, for a time of 3000 seconds, to form a coating I.

Thereafter, β-(3,4-epoxycyclohexyl)-ethyltrimethoxysilane and 2-perfluorooctyl ethyl acrylate were vaporized at a temperature of 180 °C and introduced at a flow rate of 75 µL/min, respectively, into the plasma chamber, followed by starting plasma discharge with a supply power of 180 W, a frequency of 45 Hz and a duty factor of 1.5%, for a reaction time of 5400 seconds, to form a coating II.

When the discharge was over, compressed air was introduced to restore the chamber to normal pressure, to open the chamber and take out the circuit board, the Mg sheet, the Fe sheet and the mobile phone screen. And, the Mg sheet and the Fe sheet were tested for the coating thicknesses thereon and for salt spray resistance, and results thereof were listed in Table 1. The circuit board was tested for the coating thickness thereon and for friction resistance, and results thereof were listed in Table 2. The mobile phone screen was tested for friction resistance, and results thereof were listed in Table 3.

### Example 2

A circuit board, a Mg sheet and a Fe sheet were placed in a plasma chamber. The chamber was then evacuated to 80 millitorr, and introduced with helium at a flow rate of 140 sccm, followed by starting plasma discharge for pertreatment with a discharge power of 180 W, for continuous discharge of 300 seconds, during this pretreatment stage.

Then, diphenyldimethoxysilane and a mixed monomer of 1,6-hexanediol diacrylate and phenyl acrylate (mass ratio of 3:2) were vaporized at a temperature of 180 °C and introduced at a flow rate of 400 ul/min, respectively, into the plasma chamber, followed by starting plasma discharge with a supply power of 37 W, a frequency of 65 Hz and a duty factor of 45%, for a time of 3800 seconds, to form a coating I.

Thereafter, phenyltrimethoxysilane and 1H,1H,2H,2H-perfluorooctyl acrylate were vaporized at a temperature of 145 °C and introduced at a flow rate of 80 µL/min, respectively, into the plasma chamber, followed by starting plasma discharge with a supply power of 180 W, a frequency of 65 Hz and a duty factor of 1%, for a reaction time of 6000 seconds, to form a coating II.

When the discharge was over, compressed air was introduced to restore the chamber to normal pressure, to open the chamber and take out the circuit board, the Mg sheet and the Fe sheet. And, the Mg sheet and the Fe sheet were tested for the coating thicknesses thereon and for salt spray resistance, and results thereof were listed in Table 1. The circuit board was tested for the coating thickness thereon and for friction resistance, and results thereof were listed in Table 2. The electrochemical test was carried out on the coated Mg sheet and the uncoated Mg sheet, to obtain a Tafel curve as shown in Figure 1, which was fitted to obtain other electrochemical parameters as listed in Table 4.

### Example 3

A circuit board, a Mg sheet and a Fe sheet were placed in a plasma chamber. The chamber was then evacuated to 60 millitorr, and introduced with helium at a flow rate of 80 sccm, followed by starting plasma discharge for pertreatment with a discharge power of 120 W, for continuous discharge of 800 seconds, during this pretreatment stage.

Then, 3-(2,3-epoxypropoxy)propyltrimethoxysilane and a mixed monomer of 1,6-hexanediol diacrylate and phenyl methacrylate (mass ratio of 2:1) were vaporized at a temperature of 180 °C and introduced at a flow rate of 300 ul/min, respectively, into the plasma chamber, followed by starting plasma discharge with a supply power of 40 W, a frequency of 45 Hz and a duty factor of 35%, for a time of 3000 seconds, to form a coating I.

Thereafter, 3-(2,3-epoxypropoxy)propylmethyldimethoxysilane and 2-perfluorooctyl ethyl acrylate were vaporized at a temperature of 180 °C and introduced at a flow rate of 75 µL/min, respectively, into the plasma chamber, followed by starting plasma discharge with a supply power of 180 W, a frequency of 45 Hz and a duty factor of 1.5%, for a reaction time of 5400 seconds, to form a coating II.

When the discharge was over, compressed air was introduced to restore the chamber to normal pressure, to open the chamber and take out the circuit board, the Mg sheet and the Fe sheet. And, the Mg sheet and the Fe sheet were tested for the coating thicknesses thereon and for salt spray resistance, and results thereof were listed in Table 1. The circuit board was tested for the coating thickness thereon and for friction resistance, and results thereof were listed in Table 2.

### Comparative Example 1

A circuit board, a Mg sheet and a Fe sheet were placed in a plasma chamber. The chamber was then evacuated to 80 millitorr, and introduced with helium at a flow rate of 140 sccm, followed by starting plasma discharge for pertreatment with a discharge power of 180 W, for continuous discharge of 300 seconds, during this pretreatment stage.

Then, γ-aminopropyltriethoxysilane and a mixed monomer of 1,6-hexanediol diacrylate and phenyl acrylate (mass ratio of 3:2) were vaporized at a temperature of 180 °C and introduced at a flow rate of 400 ul/min, respectively, into the plasma chamber, followed by starting plasma discharge with a supply power of 37 W, a frequency of 65 Hz and a duty factor of 45%, for a time of 3800 seconds, to form a coating I.

Thereafter, phenyltrimethoxysilane and 1H,1H,2H,2H-perfluorooctyl acrylate were vaporized at a temperature of 145 °C and introduced at a flow rate of 80 µL/min, respectively, into the plasma chamber, followed by starting plasma discharge with a supply power of 180 W, a frequency of 65 Hz and a duty factor of 1%, for a reaction time of 6000 seconds, to form a coating II.

When the discharge was over, compressed air was introduced to restore the chamber to normal pressure, to open the chamber and take out the circuit board, the Mg sheet and the Fe sheet. And, the Mg sheet and the Fe sheet were tested for the coating thicknesses thereon and for salt spray resistance, and results thereof were listed in Table 1. The circuit board was tested for the coating thickness thereon and for friction resistance, and results thereof were listed in Table 2.

### Comparative Example 2

A circuit board, a Mg sheet and a Fe sheet were placed in a plasma chamber. The chamber was then evacuated to 60 millitorr, and introduced with helium at a flow rate of 80 sccm, followed by starting plasma discharge for pertreatment with a discharge power of 120 W, for continuous discharge of 800 seconds, during this pretreatment stage.

Then, a mixed monomer of 1,6-hexanediol diacrylate and phenyl methacrylate (mass ratio of 2:1) were vaporized at a temperature of 180 °C and introduced at a flow rate of 600 ul/min into the plasma chamber, followed by starting plasma discharge with a supply power of 40 W, a frequency of 45 Hz and a duty factor of 35%, for a time of 3000 seconds, to form a coating I.

Thereafter, β-(3,4-epoxycyclohexyl)-ethyltrimethoxysilane and 2-perfluorooctyl ethyl acrylate were vaporized at a temperature of 180 °C and introduced at a flow rate of 75 µL/min, respectively, into the plasma chamber, followed by starting plasma discharge with a supply power of 180 W, a frequency of 45 Hz and a duty factor of 1.5%, for a reaction time of 5400 seconds, to form a coating II.

When the discharge was over, compressed air was introduced to restore the chamber to normal pressure, to open the chamber and take out the circuit board, the Mg sheet and the Fe sheet. And, the Mg sheet and the Fe sheet were tested for the coating thicknesses thereon and for salt spray resistance, and results thereof were listed in Table 1. The circuit board was tested for the coating thickness thereon and for friction resistance, and results thereof were listed in Table 2.

### Comparative Example 3

A circuit board, a Mg sheet and a Fe sheet were placed in a plasma chamber. The chamber was then evacuated to 60 millitorr, and introduced with helium at a flow rate of 80 sccm, followed by starting plasma discharge for pertreatment with a discharge power of 120 W, for continuous discharge of 800 seconds, during this pretreatment stage.

Then, a mixed monomer of 1,6-hexanediol diacrylate and methyl acrylate (mass ratio of 2:1) were vaporized at a temperature of 180 °C and introduced at a flow rate of 600 ul/min into the plasma chamber, followed by starting plasma discharge with a supply power of 40 W, a frequency of 45 Hz and a duty factor of 35%, for a time of 3000 seconds, to form a coating I.

Thereafter, β-(3,4-epoxycyclohexyl)-ethyltrimethoxysilane and 2-perfluorooctyl ethyl acrylate were vaporized at a temperature of 180 °C and introduced at a flow rate of 75 µL/min, respectively, into the plasma chamber, followed by starting plasma discharge with a supply power of 180 W, a frequency of 45 Hz and a duty factor of 1.5%, for a reaction time of 5400 seconds, to form a coating II.

When the discharge was over, compressed air was introduced to restore the chamber to normal pressure, to open the chamber and take out the circuit board, the Mg sheet and the Fe sheet. And, the Mg sheet and the Fe sheet were tested for the coating thicknesses thereon and for salt spray resistance, and results thereof were listed in Table 1. The circuit board was tested for the coating thickness thereon and for friction resistance, and results thereof were listed in Table 2.

### Comparative Example 4

A circuit board, a Mg sheet and a Fe sheet were placed in a plasma chamber. The chamber was then evacuated to 60 millitorr, and introduced with helium at a flow rate of 80 sccm, followed by starting plasma discharge for pertreatment with a discharge power of 120 W, for continuous discharge of 800 seconds, during this pretreatment stage.

Thereafter, β-(3,4-epoxycyclohexyl)-ethyltrimethoxysilane and 2-perfluorooctyl ethyl acrylate were vaporized at a temperature of 180 °C and introduced at a flow rate of 75 µL/min, respectively, into the plasma chamber, followed by starting plasma discharge with a supply power of 180 W, a frequency of 45 Hz and a duty factor of 1.5%, for a reaction time of 16000 seconds, to form a coating.

When the discharge was over, compressed air was introduced to restore the chamber to normal pressure, to open the chamber and take out the circuit board, the Mg sheet and the Fe sheet. And, the Mg sheet and the Fe sheet were tested for the coating thicknesses thereon and for salt spray resistance, and results thereof were listed in Table 1. The circuit board was tested for the coating thickness thereon and for friction resistance, and results thereof were listed in Table 2.

**Table 1. Results of the salt spray resistance tests in Examples 1-3 and Comparative Examples 1-4**

| | Salt spray resistance tests (5% NaCl solution) | | | | | |
|---|---|---|---|---|---|---|
| | Substrates | Thicknesses (nm) | Times | Substrates | Thicknesses | Times |
| Example 1 | Fe | 102 | 106 h | Mg | 108 | 64 h |
| Example 2 | Fe | 105 | 84 h | Mg | 100 | 68 h |
| Example 3 | Fe | 103 | 73 h | Mg | 106 | 56 h |
| Comparative Example 1 | Fe | 102 | 52 h | Mg | 103 | 43 h |
| Comparative Example 2 | Fe | 103 | 43 h | Mg | 105 | 35 h |
| Comparative Example 3 | Fe | 106 | 47 h | Mg | 103 | 32 h |
| Comparative Example 4 | Fe | 101 | 31 h | Mg | 102 | 15 h |

**Table 2. Results of the circuit board friction tests in Examples 1-3 and Comparative Examples 1-4**

| | Substrates | Thicknesses (nm) | Failure times |
|---|---|---|---|
| Example 1 | circuit board | 458 | 5 h 45 min |
| Example 2 | circuit board | 460 | 4 h 32 min |
| Example 3 | circuit board | 462 | 3 h 23 min |
| Comparative Example 1 | circuit board | 463 | 2 h 46 min |
| Comparative | circuit | 460 | 1 h 18 min |
| Example 2 | board | | |
| Comparative Example 3 | circuit board | 456 | 1 h 35 min |
| Comparative Example 4 | circuit board | 432 | 36 min |

**Table 3. Results of the mobile phone screen friction test in Example 1**

| | | | | |
|---|---|---|---|---|
| Mobile phone screen | Wear resistance (wca/oca) | | | |
| | 0 time | 100 times | 1000 times | 3000 times |
| | 120°/80° | 118°/79° | 112°/75° | 108°/72° |

**Table 4. Results of the electrochemical parameters in Example 2**

| Tested substrate | Thickness (nm) | Current density (A/cm²) | Corrosion potential (V) |
|---|---|---|---|
| Mg | 100 | 9.569 e⁻⁹ | -1.101 |
| | 0 | 5.322 e⁻⁵ | -1.385 |

According to the results in Tables 1 and 2, the composite coatings in Examples 1-3 have a coating formed from plasma of an unsaturated ester monomer with an aromatic ring, an ester coupling agent monomer and an organosilane monomer with an aromatic group or an epoxy group as an inner layer, and have a coating formed from plasma of a fluorine-containing acrylate monomer and an organosilane monomer with an aromatic group or an epoxy group as an outer layer, as well as have more excellent results of the salt spray resistance tests and the friction tests than composite coatings in Comparative Examples 1-4. And, the composite coating in Comparative Example 1 has a coating formed from plasma of the unsaturated ester monomer with the aromatic ring, the ester coupling agent monomer and a general organosilane monomer as an inner layer, and has a coating formed from plasma of the fluorine-containing acrylate monomer and the organosilane monomer with the aromatic group as an outer layer. The composite coating in Comparative Example 2 has a coating formed from plasma of the unsaturated ester monomer with the aromatic ring and the ester coupling agent monomer, without the organosilane monomer, as an inner layer, and has a coating formed from plasma of the fluorine-containing acrylate monomer and the organosilane monomer with the epoxy group as an outer layer. The composite coating in Comparative Example 3 has a coating formed from plasma of an unsaturated ester monomer without an aromatic ring, the ester coupling agent monomer and the organosilane monomer with the aromatic group as an inner layer, and has a coating formed from plasma of the fluorine-containing acrylate monomer and the organosilane monomer with the epoxy group as an outer layer. The composite coating in Comparative Example 4 is a coating formed from plasma of the fluorine-containing acrylate monomer and the organosilane monomer with the epoxy group. It is demonstrated that, the composite coatings in Examples 1-3 have the most excellent anti-corrosion property and wear resistance.

According to the results in Table 3, the composite coating in Example 1 as a protective coating for the mobile phone screen has very excellent waterproof and oilproof properties, even if it is rubbed 3000 times.

According to the results of the electrochemical parameters in Table 4, the uncoated Mg sheet has very poor corrosion resistance in a neutral solution of 3.6% NaCl and suffers electrochemical corrosion that has an anodic reaction which is an electron-losing dissolution process of magnesium and a cathodic reaction which is an electron-obtaining hydrogen evolution process of water. It is found through experiments that, the uncoated Mg sheet has a self-corrosion potential of -1.385, the Mg sheet with the composite coating has a self-corrosion potential of -1.101, which is reduced by 26%, and has thus enhanced corrosion resistance. At the same time, the coated Mg sheet has a current density of 9.569 e⁻⁹ A/cm², which is 4 orders of magnitude lower than a current density of the uncoated Mg sheet. It is shown that, the coated Mg sheet has better protective performance.

Although the present disclosure is disclosed as above, the present disclosure is not limited hereto. Various changes and modifications may be made by those skilled in the art without departing from the spirit and scope of the present disclosure. Thus, the scope of protection of the present disclosure shall be subject to the scope defined by the claims.

## Claims

1. A composite coating, **characterized by** comprising a coating I deposited on a substrate,
wherein, the coating I is a plasma polymeric coating formed from plasma containing a monomer α, a monomer β and a monomer y; and
the monomer α has a structure represented by formula (1-1), 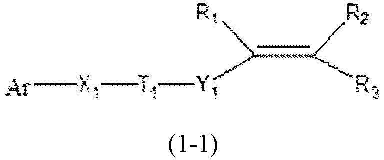
wherein, Ar is a structure with an aromatic ring, T₁ is -O-C(O)- or -C(O)-O-, X₁ is a linker, Y₁ is a linker, and R₁, R₂ and R₃ are each independently selected from a group consisting of a hydrogen atom, halogen atoms, C₁-C₁₀ alkyl groups, or C₁-C₁₀ alkyl groups substituted with a halogen atom;
the monomer β has a structure represented by formula (2-1), 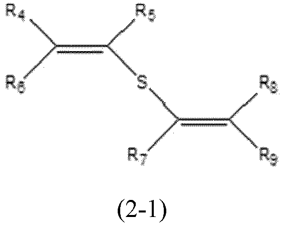
wherein, S contains above one -O-C(O)- or -C(O)-O-, and R₄, R₅, R₆, R₇, R₈ and R₉ are each independently selected from a group consisting of a hydrogen atom, halogen atoms, C₁-C₁₀ alkyl groups, or C₁-C₁₀ alkyl groups substituted with a halogen atom; and
the monomer γ has a structure represented by formula (3-1), 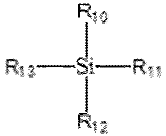 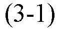
wherein, R₁₀, R₁₁, R₁₂ and R₁₃ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, and substituted or unsubstituted C₄-C₂₀ aromatic groups, and wherein, at least one of R₁₀, R₁₁, R₁₂ and R₁₃ contains an epoxy group or is a C₄-C₂₀ aromatic group.

2. The composite coating according to claim 1, **characterized in that** R₁, R₂, R₃, R₄, R₅, R₆, R₇, R₈ and R₉ are each independently selected from a group consisting of a hydrogen atom and a methyl group.

3. The composite coating according to claim 1, **characterized in that** X₁ is a structure represented by the following formula (1-2),
*-X₁₁-X₁₂-* (1-2)
wherein, X₁₁ is a linking bond, -O- or -C(O)-, and X₁₂ is a linking bond, C₁-C₁₀ alkylidene groups, or C₁-C₁₀ alkylidene groups substituted with a halogen atom; and
Y₁ is a linking bond, C₁-C₁₀ alkylidene groups, or C₁-C₁₀ alkylidene groups substituted with a halogen atom.

4. The composite coating according to claim 1, **characterized in that** Ar is a benzene ring structure or a benzene ring structure with a substituent.

5. The composite coating according to claim 4, **characterized in that** the monomer α has a structure represented by formula (1-3), 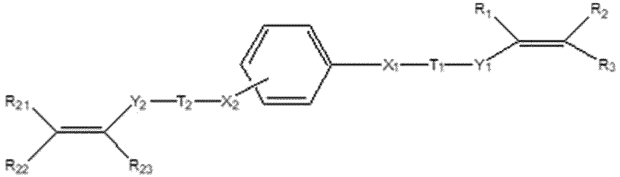 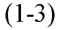 wherein, T₂ is -O-C(O)- or -C(O)-O-, X₂ is a linker, Y₂ is a linker, and R₂₁, R₂₂ and R₂₃ are each independently selected from a group consisting of a hydrogen atom, halogen atoms, C₁-C₁₀ alkyl groups, and C₁-C₁₀ alkyl groups substituted with a halogen atom.

6. The composite coating according to claim 5, **characterized in that** X₂ is a structure represented by the following formula (1-4),
*-X₂₂-X₂₁-* (1-4)
wherein, X₂₁ is a linking bond, -O- or -C(O)-, and X₂₂ is a linking bond, C₁-C₁₀ alkylidene groups, or C₁-C₁₀ alkylidene groups substituted with a halogen atom; and
Y₂ is a linking bond, C₁-C₁₀ alkylidene groups, or C₁-C₁₀ alkylidene groups substituted with a halogen atom.

7. The composite coating according to claim 5, **characterized in that** R₂₁, R₂₂ and R₂₃ are each independently selected from a group consisting of a hydrogen atom and a methyl group.

8. The composite coating according to claim 1, **characterized in that** the monomer α is at least one selected from a group consisting of 2-phenoxyethyl acrylate, benzyl acrylate, diallyl terephthalate, and phenyl methacrylate.

9. The composite coating according to claim 1, **characterized in that** S contains two selected from a group consisting of -O-C(O)- and -C(O)-O-, and x is above 4.

10. The composite coating according to claim 1, **characterized in that** S has a structure represented by formula (2-2), 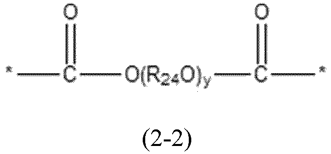 wherein, R₂₄ is C₂-C₁₀ alkylidene groups or C₂-C₁₀ alkylidene groups substituted with a halogen atom, and y is an integer from 0 to 10.

11. The composite coating according to claim 1, **characterized in that** the monomer β is at least one selected from a group consisting of 1,4-butanediol dimethacrylate, 1,6-hexanediol dimethacrylate, ethylene glycol dimethacrylate, diethylene glycol dimethacrylate, triethylene glycol dimethacrylate, tetraethylene glycol dimethacrylate, 1,3-butanediol dimethacrylate, neopentylene glycol dimethacrylate, methacrylic anhydride, diprop-2-enyl 2-methylidenebutanedioate, diprop-2-enyl 2-benzylidene propanedioate, and diallylmalonic acid diethyl ester.

12. The composite coating according to claim 1, **characterized by** further comprising a coating II, wherein the coating II is a plasma polymeric coating formed on the coating I by contacting the coating I with plasma containing a monomer δ and a monomer ε; and
the monomer δ has a structure represented by formula (4-1), 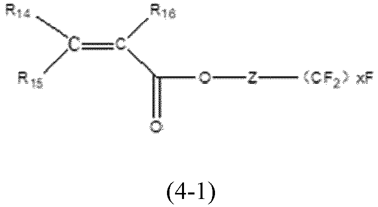
wherein, Z is a linker, R₁₄, R₁₅ and R₁₆ are each independently selected from a group consisting of a hydrogen atom, halogen atoms, C₁-C₁₀ hydrocarbyl groups, and C₁-C₁₀ hydrocarbyl groups substituted with a halogen atom, and x is an integer of 1-20; and
the monomer ε has a structure represented by formula (5-1), 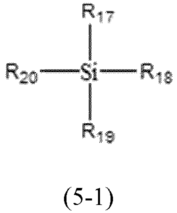
wherein, R₁₇, R₁₈, R₁₉ and R₂₀ are each independently selected from a group consisting of a hydrogen atom, halogen atoms, substituted or unsubstituted C₁-C₂₀ hydrocarbyl groups, substituted or unsubstituted C₁-C₂₀ hydrocarbyloxy groups, or substituted or unsubstituted C₄-C₂₀ aromatic groups, and wherein, at least one of R₁₇, R₁₈, R₁₉ and R₂₀ contains an epoxy group or is a C₄-C₂₀ aromatic group.

13. The composite coating according to claim 12, **characterized in that** R₁₄, R₁₅ and R₁₆ are each independently selected from a group consisting of a hydrogen atom and a methyl group.

14. The composite coating according to claim 12, **characterized in that** Z is a linking bond, C₁-C₄ alkylidene groups, or C₁-C₄ alkylidene groups with a substituent.

15. The composite coating according to claim 12, **characterized in that** the monomer δ is one or more selected from a group consisting of 3-(perfluoro-5-methylhexyl)-2-hydroxypropyl methacrylate, 2-(perfluorodecyl)ethyl methacrylate, 2-(perfluorohexyl)ethyl methacrylate, 2-(perfluorododecyl)ethyl acrylate, 2-perfluorooctyl ethyl acrylate, 1H,1H,2H,2H-perfluorooctyl acrylate, 2-(perfluorobutyl)ethyl acrylate, (2H-perfluoropropyl)-2-propenyl ether, and (perfluorocyclohexyl)methyl acrylate.

16. The composite coating according to claim 1 or 12, **characterized in that** R₁₀, R₁₁, R₁₂, R₁₃, R₁₇, R₁₈, R₁₉ and R₂₀ are each independently selected from a group consisting of a hydrogen atom, halogen atoms, C₁-C₂₀ hydrocarbyl groups, C₁-C₂₀ hydrocarbyl groups with a substituent of an epoxy structure, C₁-C₂₀ hydrocarbyloxy groups, C₁-C₂₀ hydrocarbyloxy groups with a substituent of an epoxy structure, and C₆-C₂₀ aryl groups.

17. The composite coating according to claim 16, **characterized in that** R₁₀, R₁₁, R₁₂, R₁₃, R₁₇, R₁₈, R₁₉ and R₂₀ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, and C₆-C₂₀ aryl groups, and wherein at least one of R₁₀, R₁₁, R₁₂ and R₁₃ is a C₆-C₂₀ aryl group, at least one of R₁₇, R₁₈, R₁₉ and R₂₀ is a C₆-C₂₀ aryl group.

18. The composite coating according to claim 17, **characterized in that** the aryl group is phenyl.

19. The composite coating according to claim 18, **characterized in that** the monomer γ and the monomer ε are each independently one or more selected from a group consisting of phenyltrichlorosilane, diphenylchlorosilane, diphenyldichlorosilane, triphenylvinylsilane, diphenyldivinylsilane, phenyltrivinylsilane, methylphenyldivinylsilane, dimethylphenylvinylsilane, methoxytriphenylsilane, diphenyldimethoxysilane, and phenyltrimethoxysilane.

20. The composite coating according to claim 16, **characterized in that** R₁₀, R₁₁, R₁₂, R₁₃, R₁₇, R₁₈, R₁₉ and R₂₀ are each independently selected from a group consisting of a hydrogen atom, halogen atoms, C₁-C₄ alkyl groups, C₁-C₄ alkoxy groups, C₁-C₄ alkenyl groups, C₁-C₄ alkenyloxy groups, C₂-C₁₀ epoxyhydrocarbyloxyhydrocarbyl groups, and C₂-C₁₀ epoxyhydrocarbyl groups; and wherein at least one of R₁₀, R₁₁, R₁₂ and R₁₃ is a C₂-C₁₀ epoxyhydrocarbyloxyhydrocarbyl group or a C₂-C₁₀ epoxyhydrocarbyl group, at least one of R₁₇, R₁₈, R₁₉ and R₂₀ is a C₂-C₁₀ epoxyhydrocarbyloxyhydrocarbyl group or a C₂-C₁₀ epoxyhydrocarbyl group.

21. The composite coating according to claim 20, **characterized in that** the epoxy is a cycloaliphatic epoxy.

22. The composite coating according to claim 20, **characterized in that** the monomer γ and the monomer ε are each independently one or more selected from a group consisting of 3-(2,3-epoxypropoxy)propylmethyldimethoxysilane, 3-(2,3-epoxypropoxy)propylmethyldiethoxysilane, 3-(2,3-epoxypropoxy)propyltrimethoxysilane, 3-(2,3-epoxypropoxy)propyltriethoxysilane, β-(3,4-epoxycyclohexyl)-ethyltrimethoxysilane, and 2-(3,4-epoxycyclohexyl)ethyltriethoxysilane.

23. The composite coating according to claim 1, **characterized in that** the substrate is a metal, a plastic, a fabric, glass, an electrical component, an optical instrument, or an electrical part.

24. A method for preparing the composite coating according to any one of claims 1 to 23, **characterized by** comprising:
providing a substrate to place it in a plasma reaction chamber, evacuating the plasma reaction chamber to 20 millitorr-250 millitorr, and introducing a gas of He, Ar, O₂ or a mixed gas thereof into the plasma reaction chamber; and
introducing a vapor of the monomer α, a vapor of the monomer β and a vapor of the monomer γ into the plasma reaction chamber, and performing plasma discharge, to form a plasma polymeric coating I.

25. The method according to claim 24, **characterized by** further comprising introducing a vapor of the monomer δ and a vapor of the monomer ε into the plasma reaction chamber, and performing plasma discharge, to form a plasma polymeric coating II on the coating I.

26. The method according to claim 24 or 25, **characterized in that** the plasma is pulsed plasma.

27. The method according to claim 26, **characterized in that** the pulsed plasma is generated by applying impulsive voltage discharge with a pulse power of 10 W-300 W, a pulse frequency of 15 Hz-60 kHz and a pulse duty factor of 1%-85%, for a plasma discharge time of 100 seconds-36000 seconds.

28. A device, **characterized by** having the composite coating according to any one of claims 1 to 23 on at least a part of a surface of the device.
